# EUROPEAN PATENT APPLICATION

(11) **EP 3 190 358 A1**
(43) Date of publication of application: **12.07.2017**
(21) Application number: 16165278.9
(22) Date of filing: 14.04.2016
(51) Int. Cl.: F25B 21/02, H01L 23/38, H01L 23/473

(54) **THERMOELECTRIC COOLING MODULE**

(30) Priority: 30.12.2015 TW 104144535
(71) Applicant: MSI Computer (Shenzhen) Co., Ltd., Shenzhen City Guangdong Province, P.R.C. Guangdong (CN)
(72) Inventor: CHEN, Cheng-Lung, Taoyuan City, (TW); WU, Ching-Chi, Keelung City, (TW); LIAO, Ting-Lun, New Taipei City, (TW)
(74) Representative: Cabinet Plasseraud

(57) **Abstract**

A thermoelectric cooling module includes a base, a thermoelectric cooler and a plurality of heat exchangers. The base includes a case and a cover. The case has an inlet and an outlet. The cover covers the case. The cover and the case together define an accommodation space. The inlet and the outlet are connected with the accommodation space for a heat transfer fluid to flow in and out of the accommodation space. The thermoelectric cooler is in thermal contact with the cover for exchanging heat with the cover. The heat exchangers are disposed on and in thermal contact with the cover. The heat exchangers extend from the cover into the accommodation space for exchanging heat with the heat transfer fluid in the accommodation space.

## Description

### Technical Field

The present disclosure provides a cooling module and a heat dissipation device, more particular to a thermoelectric cooling module and a heat dissipation device having the thermoelectric cooling module.

### Background

With the development of electronic technology, the electronic chip has been developed for featuring compact size and high computing power. With the demand of compact and efficient electronic chip, the heat generated by the electronic chip is highly increased. Thus, there is an increasing demand to provide a heat dissipation device for preventing the electronic chip from being overly hot in order to maintain the stability of the electronic chip.

Generally, a thermoelectric cooling module is able to exchange heat with the electronic chip by a heat transfer fluid to cool down the electronic chip. However, a conventional thermoelectric cooling module performs unfavorable heat dissipation capability due to low heat exchange efficiency between the heat transfer fluid and the thermoelectric cooling module. A high power thermoelectric cooling module is provided for satisfying the requirement of heat dissipation capability, but consumes high power. Thus, there is a need to develop a thermoelectric cooling module featuring high heat exchange efficiency with respect to the heat transfer fluid.

### SUMMARY

The disclosure provides a thermoelectric cooling module and a heat dissipation device including the thermoelectric cooling module, wherein the thermoelectric cooling module features high heat exchange efficiency with the heat transfer fluid.

According to the disclosure, a thermoelectric cooling module includes a base, a thermoelectric cooler and a plurality of heat exchangers. The base includes a case and a cover. The case has an inlet and an outlet. The cover covers the case. The cover and the case together define an accommodation space. The inlet and the outlet are connected with the accommodation space for a heat transfer fluid to flow in and out of the accommodation space. The thermoelectric cooler is in thermal contact with the cover for exchanging heat with the cover. The heat exchangers are disposed on and in thermal contact with the cover. The heat exchangers extend from the cover into the accommodation space for exchanging heat with the heat transfer fluid in the accommodation space.

According to the disclosure, a heat dissipation device includes the aforementioned thermoelectric cooling module, a heat exchanging member, a first tube and a second tube. The heat exchanging member is in thermal contact with a heat source. The heat exchanging member has a heat exchanging chamber for the heat transfer fluid flowing therethrough so as to remove heat generated by the heat source. The first tube is connected with the inlet of the base and the heat exchanging chamber. The second tube is connected with the outlet of the base and the heat exchanging chamber.

According to the disclosure, a heat dissipation device includes the aforementioned thermoelectric cooling module, a heat exchanging member, a cooling module, a first tube, a second tube and a third tube. The heat exchanging member is in thermal contact with a heat source. The heat exchanging member has a heat exchanging chamber for the heat transfer fluid flowing therethrough so as to remove heat generated by the heat source. The cooling module includes a heat dissipator and a fan. The heat dissipator has a cooling chamber. The fan is disposed on the heat sink for increasing amount of airflow passing through the cooling chamber of the heat dissipator. The first tube is connected with the inlet of the base and the heat exchanging chamber. The second tube is connected with the outlet of the base and the heat exchanging chamber. The third tube is connected with the heat exchanging chamber and the cooling chamber.

According to the disclosure, the thermoelectric cooler exchanges heat with the heat transfer fluid in the accommodation space via the cover and the heat exchangers so as to cool the heat transfer fluid. The heat exchangers are favorable for providing relatively larger area for the heat transfer fluid to exchange heat, thereby improving the heat exchange efficiency between the thermoelectric cooling module and the heat transfer fluid while reducing the power consumption of heat dissipation. Furthermore, the thermoelectric cooling module is able to cool the heat transfer fluid to at or below environment temperature. Moreover, during the operation, the thermoelectric cooling module of the disclosure consumes less power than that of the conventional thermoelectric cooling module.

### BRIEF DESCRIPTION OF THE DRAWINGS

The present invention will become more understood from the detailed description given hereinbelow and the accompanying drawings which are given by way of illustration only and thus are not limitative of the present invention and wherein:
FIG. 1 is a perspective view of a thermoelectric cooling module according to a first embodiment;
FIG. 2 is an exploded view of a part of the thermoelectric cooling module in FIG. 1;
FIG. 3 is another exploded view of a part of the thermoelectric cooling module in FIG. 1;
FIG. 4 is a perspective view of a heat dissipation device according to a second embodiment;
FIG. 5 is a block diagram of a thermoelectric cooler, a temperature sensor and a temperature controller of the heat dissipation device in FIG. 4; and
FIG. 6 is a perspective view of a heat dissipation device according to a third embodiment.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawings.

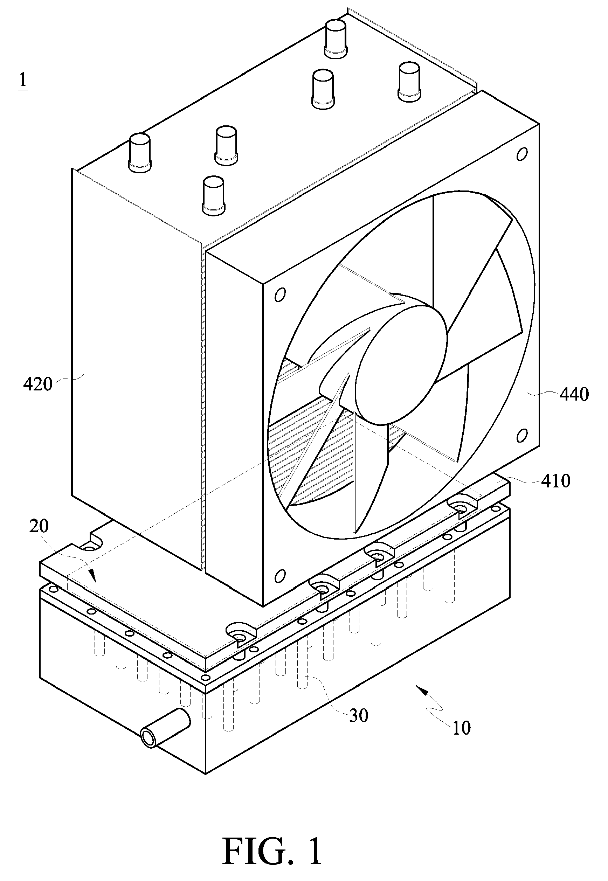

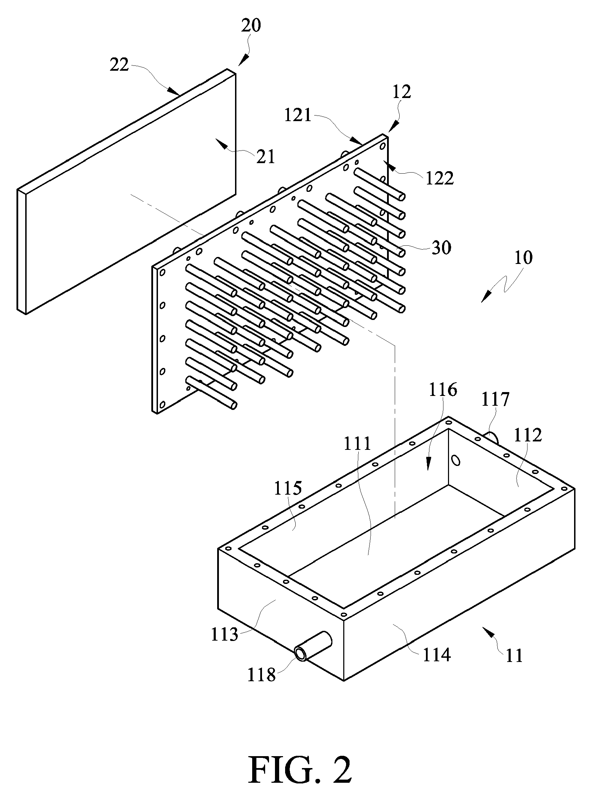

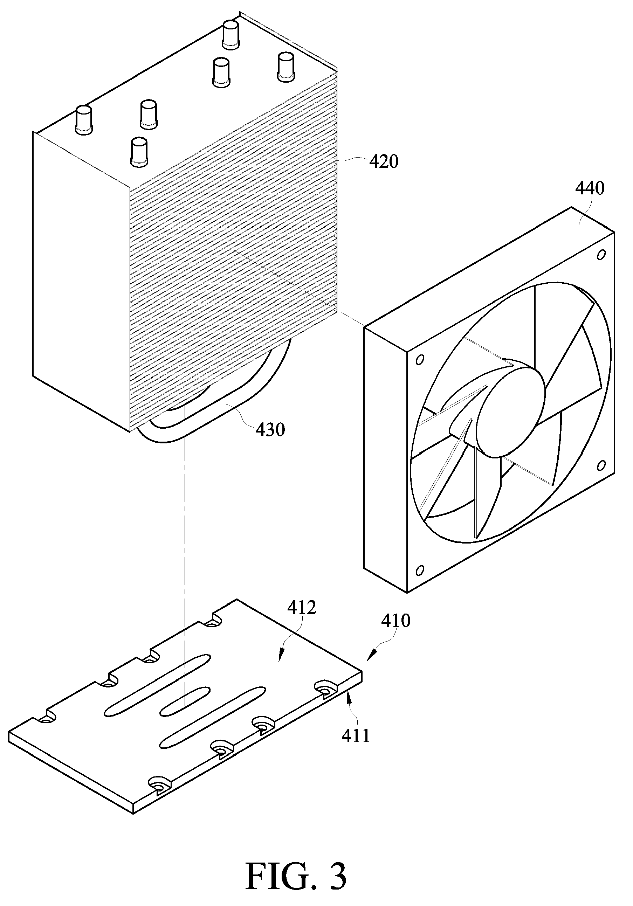

Please refer to FIG. 1 to FIG. 3. FIG. 1 is a perspective view of a thermoelectric cooling module according to a first embodiment. FIG. 2 is an exploded view of a part of the thermoelectric cooling module in FIG. 1. FIG. 3 is another exploded view of a part of the thermoelectric cooling module in FIG. 1. In this embodiment, a thermoelectric cooling module 1 is provided. The thermoelectric cooling module 1 includes a base 10, a thermoelectric cooler 20, a plurality of heat exchangers 30, a heat conducting plate 410, a heat sink 420, three heat pipes 430 and a fan 440.

The base 10 includes a case 11 and a cover 12. The case 11 includes a bottom board 111, a first side board 112, a second side board 113, a third side board 114 and a fourth side board 115. The cover 12 has a top surface 121 and a bottom surface 122 that are opposite to each other. The first side board 112, the second side board 113, the third side board 114 and the fourth side board 115 all stand on the edge of the bottom board 111. The first side board 112 faces the second side board 113. The third side board 114 faces the fourth side board 115. The third side board 114 and the fourth side board 115 are disposed between the first side board 112 and the second side board 113. The bottom board 111, the first side board 112, the second side board 113, the third side board 114, the fourth side board 115 and the cover 12 together define an accommodation space 116. The bottom surface 122 of the cover 12 faces the accommodation space 116. The case 11 has an inlet 117 and an outlet 118. The inlet 117 is located at the first side board 112. The outlet 118 is located at the second side board 113. The inlet 117 and the outlet 118 are connected with the accommodation space 116 so that a heat transfer fluid can flow in the accommodation space 116 via the inlet 117 and flow out of the accommodation space 116 via the outlet 118. In this embodiment, an orthographic projection of the outlet 118 onto the first side board 112 is spaced apart from the inlet 117; that is, there is a lateral misalignment between the axes of the inlet 117 and the outlet 118. The base 10 can be made of high thermal conductivity material such as aluminum, aluminum alloy, copper and copper alloy.

The thermoelectric cooler 20 is disposed on a top surface 121 of the cover 12. The thermoelectric cooler 20 has a cold side 21 and a hot side 22. The cold side 21 is in thermal contact with the top surface 121 of the cover 12. Therefore, when the thermoelectric cooler 20 is in operation, the cold side 21 is able to exchange heat with the cover 12 in order to cool the cover 12. In this embodiment, the quantity of the thermoelectric cooler 20 is one, but the disclosure is not limited thereto. In other embodiments, the quantity of the thermoelectric cooler can be two or more than two.

The heat exchangers 30 are disposed on and in thermal contact with the bottom surface 122 of the cover 12. Each of the heat exchangers 30 extends from the bottom surface 122 into the accommodation space 116. The heat exchangers 30 can be made of high thermal conductivity material such as aluminum, aluminum alloy, copper and copper alloy. In this embodiment, each of the heat exchanger 30 is a cylinder-shaped protrusion, but the disclosure is not limited thereto. In other embodiments, the heat exchanger can be a protrusion with non-circular shape, a plate having through holes or a fin. Furthermore, in this embodiment, the heat exchangers 30 are integral with the cover 12, but the disclosure is not limited thereto. In other embodiments, the heat exchangers 30 can be fixed to the cover 12 by welding or laser bonding.

When the thermoelectric cooler 20 is in operation, the cold side 21 of the thermoelectric cooler 20 exchanges heat with the heat transfer fluid in the accommodation space 116 via the cover 12 and the heat exchangers 30 so as to cool the heat transfer fluid. In this embodiment, the heat transfer fluid is required to flows through the heat exchangers 30 and the bottom surface 122, thus heat exchanging areas where the heat transfer fluid flows through are relatively larger than those of the conventional thermoelectric cooling module, thus the heat exchange efficiency of thermoelectric cooling module 1 is greater than the one of the conventional thermoelectric cooling module. Furthermore, when the heat transfer fluid flows through the accommodation space 116, the heat exchangers 30 interferences the heat transfer fluid, thereby increasing the traveling distance of the heat transfer fluid from the inlet 117 to the outlet 118. Therefore, there has a longer period of time during which the heat transfer fluid stays in the accommodation space 116 for exchanging heat with the heat exchangers 30 so that the heat exchange efficiency between the thermoelectric cooling module 1 and the heat transfer fluid is improved. Hence, the power consumption for the thermoelectric cooling module 1 to cool the heat transfer fluid is reduced.

Moreover, the lateral misalignment between the inlet 117 and the outlet 118 is favorable for further increasing the period of time during which the heat transfer stays in the accommodation space 116 as well as improving the heat exchange efficiency between the thermoelectric cooling module 1 and the heat transfer fluid. Therefore, the arrangement of the inlet 117 and the outlet 118 is also favorable for reducing the power for the thermoelectric cooling module 1 to cool the heat transfer fluid.

In this embodiment, the thermoelectric cooler 20 is able to cool the heat transfer fluid to below environment temperature by exchanging heat with heat exchangers 30, and the power consumption of the thermoelectric cooling module 1 is less than that of the conventional thermoelectric cooling module. In other embodiments, the power consumption of the thermoelectric cooling module 1 is also less than that of the conventional thermoelectric cooling module when the thermoelectric cooler cools the heat transfer fluid to between the temperature of a heat source and the environment temperature.

The heat conducting plate 410 is disposed on the top surface 121 of the cover 12. The thermoelectric cooler 20 is disposed between the cover 12 and the heat conducting plate 410 and in thermal contact with the cover 12 and the heat conducting plate 410. The heat conducting plate 410 has a first surface 411 and a second surface 412 that are opposite to each other. The first surface 411 is in thermal contact with the hot side 22 of the thermoelectric cooler 20. The heat conducting plate 410 can be made of high thermal conductivity material such as aluminum, aluminum alloy, copper and copper alloy. The heat sink 420 is in thermal contact with the heat pipes 430. The heat pipes 430 are in thermal contact with the second surface 412 of the heat conducting plate 410. Therefore, when the thermoelectric cooler 20 is in operation, heat generated by the thermoelectric cooler 20 is transferred to the heat sink 420 via the hot side 22, the heat conducting plate 410 and the heat pipes 430. The fan 440 is disposed on the heat sink 420. The fan 440 is favorable for increasing an amount of airflow passing through the heat sink 420 so as to improve the heat dissipation efficiency.

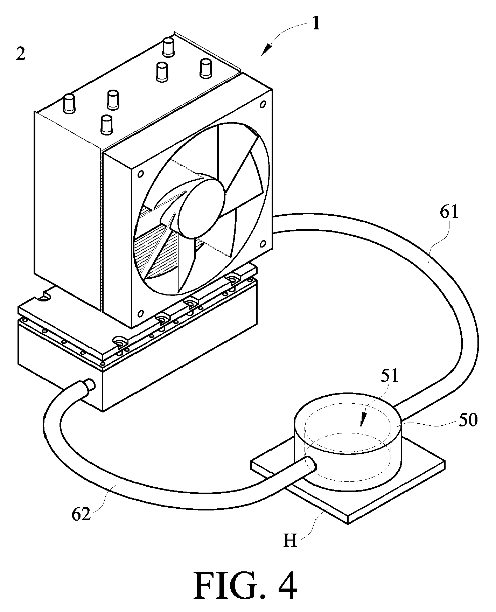

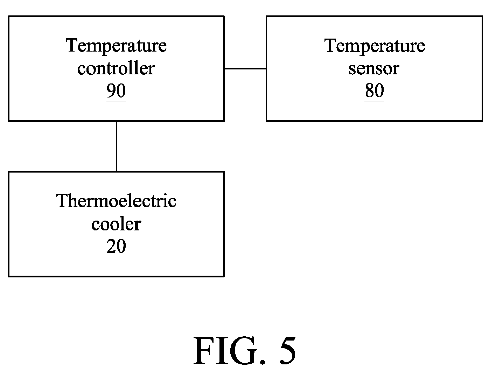

The thermoelectric cooling module 1 is applicable to a heat dissipation device. Please refer to FIG. 4 and FIG. 5. FIG. 4 is a perspective view of a heat dissipation device according to a second embodiment. FIG. 5 is a block diagram of a thermoelectric cooler, a temperature sensor and a temperature controller of the heat dissipation device in FIG. 4. In this embodiment, a heat dissipation device 2 is provided. The heat dissipation device 2 includes the thermoelectric cooling module 1 according to the first embodiment, a heat exchanging member 50, a first tube 61, a second tube 62, a temperature sensor 80 and a temperature controller 90.

The heat exchanging member 50 is for in thermal contact with a heat source H. The heat exchanging member 50 has a heat exchanging chamber 51. When the heat transfer fluid flows through the heat exchanging chamber 51 of the heat exchanging member 50, the heat transfer fluid remove heat generated by the heat source H via the heat exchanging member 50.

The first tube 61 is connected with the inlet 117 of the thermoelectric cooling module 1 and the heat exchanging chamber 51. The second tube 62 is connected with the outlet 118 of the thermoelectric cooling module 1 and the heat exchanging chamber 51. The heat transfer fluid flows into the heat exchanging chamber 51 of the heat exchanging member 50 and removes heat generated by the heat source H so as to raise the temperature of the heat transfer fluid. Then, the heat transfer fluid with high temperature flows into the accommodation space 116 of the thermoelectric cooling module 1 via the first tube 61 and the inlet 117. When the heat transfer fluid with high temperature flows into the accommodation space 116, the heat exchangers 30 exchange heat with the heat transfer fluid so that the heat transfer fluid is cooled to at a relatively low temperature. The cooled heat transfer fluid flows out of the accommodation space 116 via the outlet 118 and then flows back into the heat exchanging chamber 51 via the second tube 62 to complete a cycle of heat transfer in the heat dissipation device 2.

In this embodiment, a pump (not shown in the drawings) can be provided for driving the heat transfer fluid to flow in the heat dissipation device 2. For example, the pump can be connected between the inlet 117 of the thermoelectric cooling module 1 and the heat exchanging chamber 51 of the heat exchanging member 50, or alternatively connected between the outlet 118 of the thermoelectric cooling module 1 and the heat exchanging chamber 51 of the heat exchanging member 50.

The temperature sensor 80 is in thermal contact with the heat source H for sensing the temperature of the heat source H. The temperature controller 90 is coupled with the thermoelectric cooler 20 and the temperature sensor 80, and the temperature controller 90 is adapted for inputting a load voltage to the thermoelectric cooler 20 according to the temperature of the heat source H provided by the temperature sensor 80. In detail, the temperature controller 90 determines the value of the load voltage for the thermoelectric cooler 20 to cooling the heat source H to a determined temperature according to the temperature information of the heat source H received by the temperature controller 90. The temperature controller 90 is able to immediately adjust the value of the load voltage applied to the thermoelectric cooler 20 according to the temperature of the heat source H. Therefore, the temperature controller 90 provides a real time control of the value of the load voltage so that it is prevented from providing overly large amount of energy to cool the heat source H, thereby reducing the power consumption of the thermoelectric cooling module 1.

In this embodiment, the heat dissipation device 2 can be applicable to cool a central processing unit (CPU, not shown in the drawings) in a computer. For example, the heat exchanging member 50 of the heat dissipation device 2 is in thermal contact with the CPU. The thermoelectric cooling module 1 is disposed on a case (not shown in the drawings) of the computer, and the heat transfer fluid flows through the first tube 61 and the second tube 62. Thus, the heat transfer fluid is able to flow through the heat exchanging chamber 51 of the heat exchanging member 50 and the accommodation space 116 of the base 10. In other embodiments, the heat dissipation device 2 can be applicable to a processing unit in a graphic card or a server. According to an experimental result, when the heat dissipation device 2 cools the CPU by 1 Celsius degree (°C), the heat dissipation device 2 consumes about 7∼9 watts (W); however, when the temperature of the CPU increases by 1 °C, the additional power consumption for maintaining the working efficiency of the CPU is more than 13 W. Thus, it is believable that an electronic device equipped with the heat dissipation device 2 consumes less power during operation.

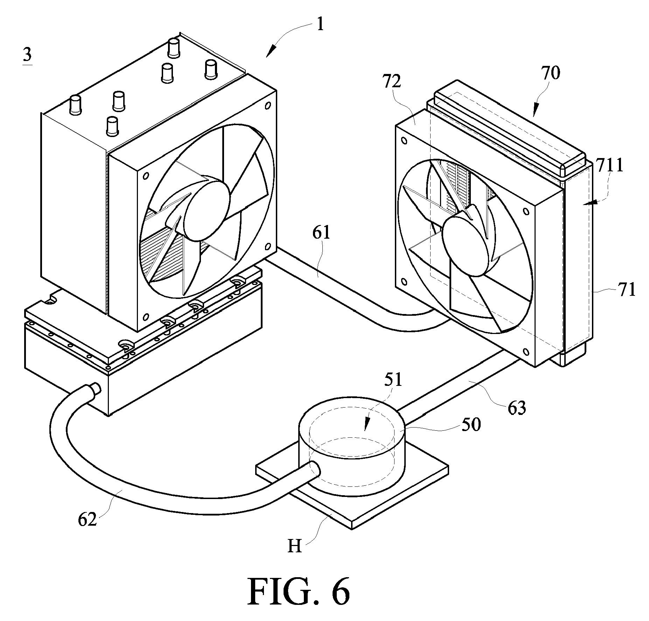

Then, please refer to FIG. 6. FIG. 6 is a perspective view of a heat dissipation device according to a third embodiment. Since the third embodiment is similar to the second embodiment, only the differences will be illustrated hereafter.

In this embodiment, a heat dissipation device 3 is provides. The heat dissipation device 3 includes the thermoelectric cooling module 1 according to the first embodiment, a heat exchanging member 50, a first tube 61, a second tube 62, a third tube 63, a cooling module 70, a temperature sensor 80 and a temperature controller 90. The cooling module 70 includes a heat dissipator 71 and a fan 72. The heat dissipator 71 has a cooling chamber 711. The fan 72 is disposed on the heat dissipator 71 for increasing the amount of airflow passing through the heat dissipator 71, thereby improving the heat dissipation efficiency of the heat dissipator 71.

The first tube 61 is connected with the inlet 117 of the thermoelectric cooling module 1 and the cooling chamber 711 of the heat dissipator 71. The second tube 62 is connected with the outlet 118 of the thermoelectric cooling module 1 and the heat exchanging chamber 51 of the heat exchanging chamber 51. The third tube 63 is connected with the heat exchanging chamber 51 and the cooling chamber 711. The heat transfer fluid flows into the heat exchanging chamber 51 of the heat exchanging member 50 and removes heat generated by the heat source H so as to raise the temperature of the heat transfer fluid. The heat transfer fluid with high temperature flows into the cooling chamber 711 of the heat dissipator 71 via the third tube 63, and is cooled by the heat dissipator 71. Then, the heat transfer fluid flows from the cooling chamber 711 into the accommodation space 116 of the thermoelectric cooling module 1 via the first tube 61 and the inlet 117, and then the heat transfer fluid exchanges heat with the heat exchangers 30 in the accommodation space 116 so that the heat transfer fluid is cooled again to at a relatively low temperature. The cooled heat transfer fluid flows out of the accommodation space 116 via the outlet 118 and then flows back into the heat exchanging chamber 51 via the second tube 62 to complete a cycle of heat transfer in the heat dissipation device 3.

In this embodiment, a pump (not shown in the drawings) can be provided for driving the heat transfer fluid to flow in the heat dissipation device 3. For example, the pump can be connected between the inlet 117 of the thermoelectric cooling module 1 and the cooling chamber 711 of the heat dissipator 71, or connected between the cooling chamber 711 of the heat dissipator 71 and the heat exchanging chamber 51 of the heat exchanging member 50, or alternatively connected between the outlet 118 of the thermoelectric cooling module 1 and the heat exchanging chamber 51 of the heat exchanging member 50.

According to this embodiment of the disclosure, the heat transfer fluid is cooled by the cooling module 70 and then further cooled by the thermoelectric cooling module 1. Therefore, the load of the thermoelectric cooling module 1 for cooling the heat transfer fluid is reduced so that the load voltage applied to the thermoelectric cooler 20 is also reduced. Hence, the power consumption of the heat dissipation device 3 for heat dissipation is reduced.

According to an experimental result, when the heat dissipation device 3 cools down the CPU by 1 °C, the power which the heat dissipation device 3 consumes about 3∼5 W; however, when the temperature of the CPU increases by 1 °C, the additional power consumption for maintaining the working efficiency of the CPU is more than 13 W. Thus, it is believable that an electronic device equipped with the heat dissipation device 3 consumes less power consumption during the operation.

According to the disclosure, the thermoelectric cooler exchanges heat with the heat transfer fluid in the accommodation space via the cover and the heat exchangers so as to cool the heat transfer fluid. The heat exchangers are favorable for providing relatively large area for the heat transfer fluid to exchange heat, thereby improving the heat exchange efficiency between the thermoelectric cooling module and the heat transfer fluid while reducing the power consumption of heat dissipation. Furthermore, the thermoelectric cooling module is able to cool the heat transfer fluid to at or below environment temperature. Moreover, during the operation, the thermoelectric cooling module of the disclosure consumes less power than that of the conventional thermoelectric cooling module.

The foregoing description, for the purpose of explanation, has been described with reference to specific embodiments; however. The embodiments were chosen and described in order to best explain the principles of the disclosure and its practical applications, to thereby enable others skilled in the art to best utilize the disclosure and various embodiments with various modifications as are suited to the particular use contemplated. The embodiments depicted above and the appended drawings are exemplary and are not intended to be exhaustive or to limit the scope of the disclosure to the precise forms disclosed. Modifications and variations are possible in view of the above teachings.

## Claims

1. A thermoelectric cooling module, comprising:
a base comprising a case and a cover, the case having an inlet and an outlet, the cover covering the case, the cover and the case together defining an accommodation space, the inlet and the outlet connected with the accommodation space for a heat transfer fluid to flow in and out of the accommodation space;
a thermoelectric cooler in thermal contact with the cover for exchanging heat with the cover; and
a plurality of heat exchangers disposed on and in thermal contact with the cover, the plurality of heat exchangers extending from the cover into the accommodation space for exchanging heat with the heat transfer fluid in the accommodation space.

2. The thermoelectric cooling module according to claim 1, further comprising a heat conducting plate, a heat sink and at least one heat pipe, wherein the thermoelectric cooler has a cold side and a hot side, the heat conducting plate is in thermal contact with the hot side, the at least one heat pipe, the heat sink and the heat conducting plate are in thermal contact with each other.

3. The thermoelectric cooling module according to claim 2, further comprising a fan disposed on the heat sink.

4. The thermoelectric cooling module according to claim 2, wherein the thermoelectric cooler is disposed between the cover and the heat conducting plate and in thermal contact with the cover and the heat conducting plate.

5. The thermoelectric cooling module according to claim 1, wherein the case comprises a first side board and a second side board that are opposite to each other, the inlet is located at the first side board, the outlet is located at the second side board, and an orthographic projection of the outlet onto the first side board is spaced apart from the inlet.

6. The thermoelectric cooling module according to claim 1, wherein each of the plurality of heat exchangers is a protrusion.

7. The thermoelectric cooling module according to claim 6, wherein each of the plurality of heat exchangers is a fin.

8. A heat dissipation device, comprising:
the thermoelectric cooling module according to claim 1;
a heat exchanging member in thermal contact with a heat source, the heat exchanging member having a heat exchanging chamber for the heat transfer fluid flowing therethrough so as to remove heat generated by the heat source;
a first tube connected with the inlet of the base and the heat exchanging chamber; and
a second tube connected with the outlet of the base and the heat exchanging chamber.

9. The heat dissipation device according to claim 8, further comprising a temperature sensor and a temperature controller, the temperature sensor in thermal contact with the heat source for sensing a temperature of the heat source, the temperature controller coupled with the thermoelectric cooler and the temperature sensor, the temperature controller for inputting a load voltage to the thermoelectric cooler according to the temperature of the heat source sensed by the temperature sensor.

10. A heat dissipation device, comprising:
the thermoelectric cooling module according to claim 1;
a heat exchanging member in thermal contact with a heat source, the heat exchanging member having a heat exchanging chamber for the heat transfer fluid flowing therethrough so as to remove heat generated by the heat source;
a cooling module comprising a heat dissipator and a fan, the heat dissipator having a cooling chamber, the fan disposed on the heat sink for increasing amount of airflow passing through the cooling chamber of the heat dissipator;
a first tube connected with the inlet of the base and the heat exchanging chamber;
a second tube connected with the outlet of the base and the heat exchanging chamber; and
a third tube connected with the heat exchanging chamber and the cooling chamber.

11. The heat dissipation device according to claim 10, further comprising a temperature sensor and a temperature controller, the temperature sensor in thermal contact with the heat source for sensing a temperature of the heat source, the temperature controller coupled with the thermoelectric cooler and the temperature sensor, the temperature controller being for inputting a load voltage to the thermoelectric cooler according to the temperature of the heat source sensed by the temperature sensor.
